Europäisches Patentamt

European Patent Office

Office européen des brevets

(11) Publication number: **0 122 095**
**B1**

# EUROPEAN PATENT SPECIFICATION

(45) Date of publication of patent specification: **07.02.90**

(21) Application number: **84302204.7**

(22) Date of filing: **30.03.84**

(51) Int. Cl.⁵: **H 03 D 3/00,** H 04 N 5/92,
H 03 C 3/06, H 03 C 3/09

(54) Circuit for reducing offset error in FM detection.

(30) Priority: **08.04.83 US 483325**

(43) Date of publication of application:
**17.10.84 Bulletin 84/42**

(45) Publication of the grant of the patent:
**07.02.90 Bulletin 90/06**

(84) Designated Contracting States:
**CH DE FR GB LI NL**

(56) References cited:
**DE-A-2 145 332**
**US-A-3 191 129**
**US-A-3 297 965**
**US-A-3 518 362**
**US-A-3 614 648**
**US-A-4 006 429**

(73) Proprietor: **AMPEX CORPORATION**
**401 Broadway M.S. 3-35**
**Redwood City California 94063-3199 (US)**

(72) Inventor: **Lilley, Martin A.**
**1485 Deschutes Place**
**Fremont California (US)**

(74) Representative: **Horton, Andrew Robert Grant
et al**
**BOWLES HORTON Felden House Dower Mews
High Street
Berkhamsted Hertfordshire HP4 2BL (GB)**

Courier Press, Leamington Spa, England.

## Description

The invention relates to offset error reduction, and particularly to a circuit for minimizing the offset error introduced by a frequency modulation (FM) detector in an automatic frequency control loop.

In an automatic frequency control system such as used in a videotape recorder, an FM detector is used to detect frequency differences between a reference (blanking level) signal and the radio frequency signal which is modulated by the video signal. It is commonplace to switch alternately between these two signals and to use quadrature detectors. However, an offset error may be introduced if the switched reference signal (usually obtained from a crystal oscillator) and the modulated RF signal have an unequal mark/space ratio. Furthermore, the offset varies for different FM detector integrated circuits. By way of explanation, an unequal mark/space ratio is associated with the generation of a second harmonic, and for minimum second harmonic component in the RF signal the mark/space ratio is ideally unity. An FM detector can be very sensitive to the mark/space ratio, and may produce an output error for signals of the same frequency but slightly different mark/space ratio.

Offset errors may also be generated by a lack of stability of the circuit with variation in temperature. The effects of temperature may be seen when a videotape recorder system first is turned on; large offset errors which are present initially disappear after several minutes, whereupon the offset stabilizes. Such unstable operation is not acceptable in a videotape recorder system, where the advantages inherent in an AFC circuit are lost if the circuit is not stable immediately it is switched on.

### Discussion of the Background Art

Various schemes have been proposed to circumvent the problems caused by offset errors and their effects on the blanking level. Predominant among these schemes is the concept of operating a blanking level oscillator and an FM modulator at twice the usual operating frequency, and then dividing the frequency of the combined signal by two prior to FM detection to ensure a unity mark/space ratio signal. Although such a scheme is successful in solving the problem of excessive and unstable offset error caused by a second harmonic component at the FM detector input, it causes other problems in the form of unacceptable crosstalk.

Another scheme uses an FM detector which inherently is not susceptible to the presence of a second harmonic and thus is somewhat immune to offset error. However, the sensitivity of the detector is extremely low, and provides an insufficient signal-to-noise ratio in the detected video signal.

A further scheme, wherein the input of the detector is tuned to remove the second harmonic component, is partially successful. However, such a scheme has the disadvantage of requiring a further adjustment, and the adjustment which is required merely shifts the offset error.

More particularly, in an AFC system, if an unstable second harmonic component exists in the signal generated by switching between the modulator RF signal and the blanking level oscillator signal, the blanking level frequency from the modulator will drift. This causes the production of a spurious error signal in the AFC feedback loop; thus the FM modulator may change its output frequency when in fact it should not.

### Brief Summary of Features and Advantages of the Invention

One aspect of the invention is the reduction of offset error introduced by an FM detector by selectively inverting the phase of the switched RF signal prior to the detection thereof to allow subsequent cancellation of the error.

Another aspect is to reduce the effects of second harmonic distortion in a switched blanking level/modulator RF signal by inverting the phase of the RF signal and then, after detection, integrating the resulting alternating offset errors to cancel them.

Yet another aspect is to provide an AFC circuit which is insensitive to second harmonic distortion, temperature changes, and variations in the characteristics of different FM detector IC's.

It is known from US—A—4,006,429 to provide an automatic frequency control circuit comprising a modulator providing an RF signal which is modulated in frequency, a source of a reference RF signal, means for producing a combined signal by alternately switching between the modulated and reference signals, an FM detector for the combined signal, means for taking samples of the output of the detector and means for forming a frequency control signal for the modulator by averaging the differences between the samples of each of a succession of pairs of samples, the samples in each pair being derived from the said modulated signal and the reference signal respectively, and offset error in the combined signal being exhibited with alternating polarity from one pair of samples to the next.

The present invention is characterised by a phase inverter which inverts the phase of the combined signal before the detection thereof at half the said switching rate.

In a practical embodiment of the invention, the modulator provides modulation of the RF signal by a video signal, the reference signal represents a blanking level and the said switching is at half a television line rate.

### Brief Description of the Drawings

Figure 1 is a block diagram illustrating the configuration of the invention within an automatic frequency control system;

Figure 2 is a schematic diagram of one embodiment of the invention combination; and Figure 3 is a graph depicting waveforms generated at various points in the circuit of Figures 1 and 2.

## Detailed Description

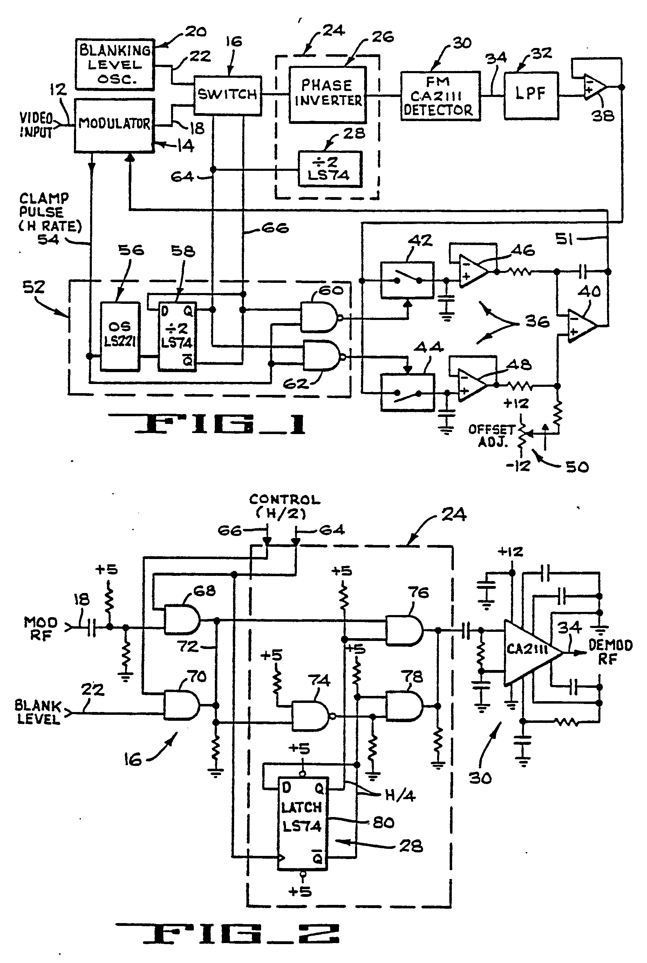

Referring to Figure 1, a video signal is supplied to an input 12 of an FM modulator 14, which supplies a modulated RF signal to two-by-one switch means 16 via a line 18. Blanking level oscillator means 20, corresponding to an ordinary reference black level generator, supplies a blanking level signal corresponding to video blanking level frequency, to the switch means 16 via a line 22. Switch means 16 supplies a switched RF signal to phase inverting means 24, which includes a phase inverter 26 and a divide-by-two (÷2) latch 28 coupled to the inverter 26. The output of phase inverting means 24 is coupled to an FM detector 30, and thence to a low-pass filter 32 via a line 34. The filter is coupled to sample/hold (S/H) means 36 via a buffer stage 38, which provides a low impedance input to the sample/hold means. The sample/hold means 36 are coupled to a difference amplifier and integrator 40 of which the output is fed back to the FM modulator 14 as the automatic frequency control error signal.

The sample/hold means 36 includes a pair of S/H circuits 42, 44 and respective associated difference amplifiers 46, 48, in first and second signal paths, respectively. The outputs of amplifiers 46, 48 are supplied to the inverting and non-inverting inputs respectively of the difference amplifier 40. An offset adjust means 50, comprising an adjustable potentiometer, is coupled to the positive input of the amplifier 40, and provides partial adjustment for offset errors.

A control means 52 provides timing pulses to the various circuit components in response to a horizontal line rate (H-rate) clamp pulse on a line 54 from the modulator video input clamp. H-rate for the clamp pulse in an NTSC, 525 line, video system is 15.750 kiloHertz (kHz), as employed herein by way of example only. The clamp pulse is used to clamp the video input signal prior to modulation in the FM modulator means 14. Control means 52 includes a one-shot multivibrator 56 coupled to the clamp pulse line 54, and thence to the clock input of a divide-by-two (÷2) latch 58. By way of example only, the one-shot 56 has a delay of 50 microseconds (μs) and the divide-by-two latch 58 is a D-type flip-flop.

The true and not-true outputs of latch 58 are coupled to first inputs of a pair of NAND gates 62 and 60 respectively, and the clamp pulse line 54 is coupled to the second inputs thereof. The outputs of the NAND gates 60, 62 supply alternate timing pulses to the control inputs of the S/H circuits 42, 44 respectively. The not-true output of the latch 58 is coupled to switch means 16 via a line 66, and the true output is coupled via line 64 to the switch means 16 as well as to the ÷2 latch 28. to synchronize operation thereof.

In operation, the modulator RF signal on line 18, and the blanking level signal on line 22 (7.9 megaHertz), are alternately switched to the input of the phase inverter 26 by the switch means 16, at one-half the clamp pulse rate, i.e. H/2 = 7.8 kHz. The switching is controlled via the latch 58 and lines 64,66. Though it is desirable that this switching have a unity mark/space ratio, in general the switching waveform will not have the required symmetry.

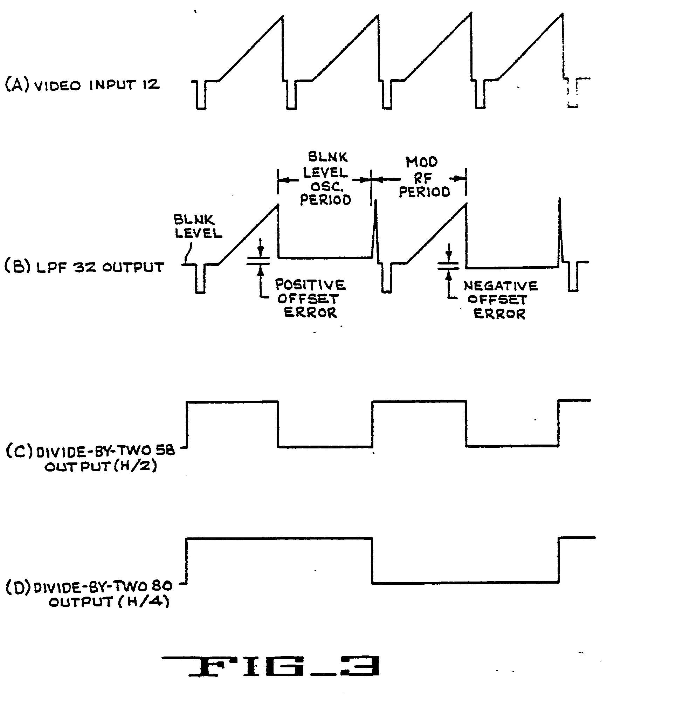

The phase of the switched RF signal is inverted by the phase inverter 26, in response to the latch 28, at a H/4 rate, i.e. 3.9 kHz. The inversion thus is performed on alternate pairs of television lines, as further described in Figures 2 and 3. The inverted signal includes any mark/space ratio error; the polarity of the mark/space ratio error is reversed while the amplitide is preserved. The switched signal is demodulated via the FM detector means 30 to provide a video signal containing information representing the difference between the blanking level and the input modulating (video) signal, and is filtered and supplied to the sample/hold means 36. The S/H circuits 42, 44 are switched via the NAND gates 60,62 at a H/2 (7.8 kHz) rate. The S/H circuit 42 storing the D.C.level corresponding to the frequency of the oscillator 20 and the S/H circuit 44 storing the DC level corresponding to the modulator frequency. Differential amplifier/ integrator 40 provides a DC signal whose amplitude is the AFC error signal with minimal offset errors. The DC signal is fed back to the FM modulator means 14 via the output line 51 to correct the modulator frequency.

Referring to Figure 2, an implementation of the phase inverting means 24 is depicted, wherein similar components are similarly numbered. Thus, the modulator RF signal on line 18 is AC coupled to a first AND gate 68 of the two-by-two switch means 16, and the blanking level signal on line 22 is coupled to a second AND gate 70. The gates 68, 70 are switched at the H/2 rate via lines 64, 66, to alternately place the modulator RF signal or the blanking level signal onto a common input 72 of the phase inverter 26.

Phase inverter 26 includes an inverting AND gate 74 coupled to the input 72 at one input. The input line 72, and the output of inverting AND gate 74, are coupled respectively to first inputs of a pair of switching AND gates 76, 78. A D-type flip-flop 80 corresponding to the divide-by-two latch 28 of Figure 1, is clocked by the timing signal on line 64 and, in turn, provides timing signals via its true and not-true outputs, to the second inputs of the AND gates 76 and 78 respectively, at the H/4 rate. The outputs of AND gates 76, 78 are AC coupled via a common line to the FM detector means 30, herein depicted by way of example only, as a CA2111 manufactured by RCA. The detector means 30 supplies the demodulated RF signal, which now is alternating lines of video and blanking level, with the alternating offset errors, to the filter 32 via the line 34. The video signal thus detected with alternating offset errors is then fed to the sample/hold means 36 to cancel the errors, as previously described.

Figure 3 depicts by way of example, the waveforms generated at various points in the circuit of Figures 1 and 2. Thus, Figure 3A depicts the video input signal supplied at input 12. Figure 3C depicts the H/2 rate timing signals supplied to the switch means 16 from the latch 58 *via* lines 64, 66. Figure 3B depicts the signal which is generated at the output of the low-pass filter 32 and which has been demodulated by the FM detector 30 and filtered; this Figure also depicts the alternating positive and negative offset errors which are subsequently cancelled by the integration process. Figure 3D depicts the timing signals which are obtained from the latch 80 at the H/4 rate and control the operation of the AND gates 76, 78.

## Claims

1. An automatic frequency control circuit comprising a modulator (14) providing an RF signal which is modulated in frequency, a source (20) of a reference RF signal, means (16) for producing a combined signal by alternately switching between the modulated and reference signals, an FM detector for the combined signal, means (42, 44) for taking samples of the output of the detector and means (40) for forming a frequency-control signal for the modulator, by averaging the differences between the samples of each of a succession of pairs of samples, the samples in each pair being derived from the said modulated signal and the reference signal respectively, and offset error in the combined signal being exhibited with alternating polarity from one pair of samples to the next, characterised by a phase inverter (26) which inverts the phase of the combined signal before the detection thereof at half the said switching rate.

2. A control circuit according to claim 1 in which the modulator provides modulation of the RF signal by a video signal, the reference signal represents a blanking level and the said switching is at half a television line rate.

3. A control circuit according to claim 1 or claim 2 in which the means (42, 44) for taking samples comprises two sample and hold means which are arranged to take alternate samples of the output of the detector at the rate of the said switching.

4. A control circuit according to claim 3 in which the means (40) for forming the frequency control signal comprises a difference amplifier and integrator coupled to the sample and hold means.

## Patentansprüche

1. Automatische Frequenzregel-Schaltungsanordnung mit einem ein frequenzmoduliertes HF-Signal liefernden Modulator (14), einer Quelle (20) für ein Referenz-HF-Signal, eine Anordnung (16) zur Erzeugung eines kombinierten Signals durch abwechselndes Umschalten zwischen dem modulierten Signal und dem Referenz-Signal, einem FM-Detektor für das kombinierte Signal, einer Anordnung (42, 44) zur Entnahme von Abtastwerten aus dem Ausgangssignal des Detektors und mit einer Anordnung (40) zur Erzeugung eines Frequenz-Regelsignals für den Modulator durch Ausmittelung der Differenzen zwischen Abtastwerten aus jedem Paar von Abtastwerten einer Folge von Abtastwertpaaren, wobei die Abtastwerte in jedem Paar aus dem modulierten Signal bzw. dem Referenz-Signal abgeleitet sind und wobei ein Offset-Fehler im kombinierten Signal mit abwechselnder Polarität von einem Paar von Abtastwerten zum nächsten auftritt, gekennzeichnet durch einen Phaseninverter (26), welcher die Phase des kombinierten Signals vor dessen Detektion mit der halben Umschalt-Folgefrequenz invertiert.

2. Regel-Schaltungsanordnung nach Anspruch 1, in welcher der Modulator die Modulation des HF-Signals durch ein Videosignal erzeugt, das Referenz-Signal einen Austastpegel repräsentiert und die Umschaltung mit der halben Fernseh-Zeilenfolgefrequenz erfolgt.

3. Regel-Schaltungsanordnung nach Anspruch 1 oder 2, in welcher die Anordnung (42, 44) zur Entnahme von Abtastwerten zwei Abtast- und Haltekreise aufweist, welche so ausgelegt sind, daß sie abwechselnde Abtastwerte des Ausgangssignals des Detektors mit der Umschalt-Folgefrequenz entnehmen.

4. Regel-Schaltung nach Anspruch 3, in welcher die Anordnung (40) zur Erzeugung des Frequenz-Regelsignals einen zu den Abtast-und Haltekreise gekoppelt Differenz-Verstärker und Integrator aufweist.

## Revendications

1. Circuit de contrôle automatique fréquence comprenant un modulateur (14) fournissant un signal FR qui est modulé en fréquence, une source (20) d'un signal FR de référence, un moyen (16) servant à produire un signal combiné par la commutation alternée entre les signaux modulé et de référence, un détecteur MF pour le signal combiné, un moyen (42, 44) servant à prélever des échantillons de la sortie du détecteur et un moyen (40) servant à former un signal de contrôle de fréquence pour le modulateur, par l'établissement de la moyenne des différences entre les échantillons de chacune d'une succession des paires d'échantillons, les échantillons dans chaque paire étant obtenus à partir dudit signal modulé et du signal de référence, respectivement, et l'erreur de décalage dans le signal combiné étant présentée avec une polarité alternée d'une paire d'échantillons à la suivante, caractérisé par un inverseur de phase (26) qui inverse la phase du signal combiné avant sa détection à la demi dite fréquence de commutation.

2. Circuit de contrôle selon la revendication 1, dans lequel le modulateur assure la modulation du signal FR par un signal vidéo, le signal de référence représente un niveau de suppression et ladite commutation est effectuée à une demi-fréquence de ligne de télévision.

3. Circuit de contrôle selon la revendication 1 ou 2, dans lequel le moyen (42, 44) pour prélever des échantillons comprend deux moyens échantillonneur/ bloqueur qui sont disposés pour prélever des échantillons alternés de la sortie du détecteur à la fréquence de ladite commutation.

4. Circuit de contrôle selon la revendication 3. dans lequel le moyen (40) servant à former le signal de contrôle de fréquence comprend un amplificateur et intégrateur de différence relié moyens échantillonneur/bloqueur.

FIG_1

FIG_2

EP  0 122 095  B1

(A) VIDEO INPUT 12

BLNK LEVEL OSC. PERIOD    MOD RF PERIOD

BLNK LEVEL

(B) LPF 32 OUTPUT

POSITIVE OFFSET ERROR    NEGATIVE OFFSET ERROR

(C) DIVIDE-BY-TWO 58 OUTPUT (H/2)

(D) DIVIDE-BY-TWO 80 OUTPUT (H/4)

FIG_3

2